# EUROPÄISCHE PATENTSCHRIFT

(11) **EP 0 993 591 B1**
(45) Veröffentlichungstag und Bekanntmachung des Hinweises auf die Patenterteilung: **13.03.2002**
(21) Anmeldenummer: 98938664.4
(22) Anmeldetag: 27.06.1998
(51) Int. Cl.: G01D 5/347

(54) **DREHWINKELSENSOR**
SENSOR FOR ANGLES OF ROTATION
CAPTEUR D'ANGLE DE ROTATION

(30) Priorität: 03.07.1997 DE 19728313
(43) Veröffentlichungstag der Anmeldung: 19.04.2000
(73) Patentinhaber: ZF Luftfahrttechnik GmbH, 34379 Calden (DE)
(72) Erfinder: POHL, Bernhard, D-93149 Nittenau (DE)
(74) Vertreter: Zietlow, Karl-Peter
(86) Internationale Anmeldenummer: EP9803936
(87) Internationale Veröffentlichungsnummer: WO9901720

(56) Entgegenhaltungen:
- EP-A- 0 332 244
- GB-A- 1 498 409
- PATENT ABSTRACTS OF JAPAN vol. 009, no. 191 (M-402), 7. August 1985 & JP 60 055805 A (TOSHIBA KK), 1. April 1985
- PATENT ABSTRACTS OF JAPAN vol. 007, no. 018 (P-170), 25. Januar 1983 & JP 57 175211 A (HITACHI KENKI KK), 28. Oktober 1982
- PATENT ABSTRACTS OF JAPAN vol. 006, no. 119 (E-116), 3. Juli 1982 -& JP 57 046543 A (HITACHI LTD), 17. März 1982

## Beschreibung

Die vorliegende Erfindung betrifft einen Drehwinkelsensor mit zwei gegeneinander verdrehbaren Teilen, wobei auf dem ersten Teil mehrere Abtastelemente angeordnet sind, und auf dem zweiten Teil eine in sich geschlossene ringförmige Codespur angeordnet ist.

Solche Drehwinkelsensoren werden beispielsweise in der Kraftfahrzeugtechnik als Lenkwinkelsensoren eingesetzt. Sie haben eine diskrete Winkelauflösung, die unter anderem von der Zahl und Anordnung der Abtastelemente, sowie von dem verwendeten Gray-Code abhängen. Die einzelnen Abtastelemente liefern an Ihrem Ausgang abhängig vom Gray-Code entweder ein "High" oder ein "Low", so daß alle Ausgänge zusammen ein binäres Datenwort bilden, bei dem jede Stelle (Digit) einem Ausgang eines Abtastelements entspricht.

In VDI Berichte Nr. 819, 1990, Seiten 127 ff. ist ein derartiger Lenkwinkelsensor offenbart, der auf optischer Basis funktioniert. Die Abtastelemente sind als Gabellichtschranken ausgebildet. Der Gray-Code ist als Ringspur mit lichtdurchlässigen und lichtundurchlässigen Bereichen ausgebildet. Für verschiedene Auflösungen ist die Anzahl der benötigten Sensorelemente und die Codelänge angegeben. Die Vorteile eines derartigen Lenkwinkelsensors sind eine kompakte Bauform, Verschleißfreiheit und die Eigenschaft, daß von den Ausgängen der Gabellichtschranken direkt ein digitaler Code gebildet wird.

Ein anderes Anwendungsgebiet sind Signalübertragungseinrichtungen zur Datenübertragung zwischen zwei verdrehbaren Systemen, bei denen, abhängig von einem Drehwinkelbereich, bestimmte Senderelemente bestimmten Empfängerelementen zugeordnet werden. Solche Signalübertragungseinrichtungen finden auch in der Hubschraubertechnik Anwendung, wo Meß- und Steuerdaten zwischen der Hubschrauberzelle und einem Rotor ausgetauscht werden. Zur Übertragung von 4 Datenkanälen kann es beispielsweise erforderlich sein, 8 jeweils 45° umschließende Drehwinkelbereiche voneinander zu unterscheiden.

JP-A-60 055 805 beschreibt einen Drehwinkelsensor mit zwei gegeneinander verdrehbaren Teilen, wobei auf dem ersten Teil an den Drehwinkelstellen 0°, 45°, 90° und 135° je ein Abtastelement angeordnet ist und das zweite Teil eine binäre Codespur umfaßt, die in zwei verschiedene je einem Binärzustand entsprechende und jeweils 180° umschließende Bereiche unterteilt ist.

Aufgabe der Erfindung ist, einen sehr einfach aufgebauten Drehwinkelsensor mit einer Auflösung von 45° zu schaffen, bei dem 8 Drehwinkelbereiche eindeutig voneinander unterscheidbar sind, und der ein 3-Bit Signal liefert, bei dem jeder Wert einer der 8 Drehwinkelbereiche kennzeichnet.

Erfindungsgemäß wird die Aufgabe von einem Drehwinkelsensor mit dem Merkmalen des unabhängigen Patentanspruchs gelöst.

Die erfindungsgemäße Merkmalskombination hat den Vorteil, daß direkt ein eindeutiges 3-Bit Signal erzeugt wird, dem eindeutig die verschiedenen Drehwinkelbereiche zugeordnet werden können. Von diesem 3-Bit Signal werden alle der 8 möglichen Datenworte benutzt. Bei einer Verdrehung ändert sich das 3-Bit Signal alle 45°. Dabei überstreicht jeweils ein Abtastelement eine Grenze im Gray-Code.

In vielen Einbaufällen kann es für Montage und Wartungsarbeiten vorteilhaft sein, wenn der Drehwinkelsensor geteilt ausgeführt ist. Hierfür sind die einzelnen, gegeneinander verdrehbaren Teile (Platinen) geteilt auszuführen. Das Teil, auf welchem die Codespur aufgebracht ist, läßt sich vorteilhaft entlang der 180° Teilung der Codespur teilen, ohne daß für die Codierung störende Fugen in homogenen Bereichen der Codespur entstehen.

Grundsätzlich können als Abtastelemente verschiedene Sensoren verwendet werden, wie beispielsweise mechanische Schleifkontakte, Hall-Sensoren, oder Sensoren, die auf dem kapazitiven, induktiven oder akustischen Prinzip beruhen. Je nach verwendetem Sensorprinzip unterscheiden sich die Bereiche der Codespur in ihren elektrischen, magnetischen oder akustischen Eigenschaften. Ebenso sind auch optische Gabellichtschranken verwendbar, in Kombination mit einer Codespur mit lichtdurchlässigen und lichtundurchlässigen Abschnitten. Eine besonders einfache geometrische Anordnung läßt sich jedoch erzielen, wenn die Abtastelemente Reflexlichtschranken sind, ein Bereich der Codespur lichtreflektierend ist, und der andere Bereich der Codespur lichtabsorbierend ist. Bei dieser Ausgestaltung der Erfindung ist es nicht -wie bei Gabellichtschranken- erforderlich, die Lichtsender und Lichtempfänger der Lichtschranke beiderseits der Codespur anzuordnen. Ein weiterer Vorteil der Reflexlichtschranken ist die hohe Winkelgenauigkeit im Umschaltbereich.

Ein einfacher geometrischer Aufbau wird dadurch erzielt, daß die beiden, gegeneinander verdrehbaren Teile scheibenförmig ausgebildet sind, und sich axial gegenüberstehen.

Bei entsprechend groß gewähltem Radius der Spur, sind im Bereich der Drehachse keine Funktionselemente des Drehwinkelsensors angeordnet, so daß entlang der Drehachse ein zentraler Durchlaß vorgesehen werden kann. Durch einen solchen zentralen Durchlaß können bei einem Hubschrauberrotor beispielsweise mechanische oder hydraulische Elemente in vorteilhafter Weise hindurchgeführt werden.

Im folgenden wird die Erfindung anhand der beiliegenden Zeichnungen näher erläutert, wobei
- Fig. 1: den Teil des Drehwinkelsensors, welcher die Abtastelemente aufweist,
- Fig. 2: den Teil des Drehwinkelsensors, welcher die Codespur aufweist,
- Fig. 3: eine Abwicklung der Spuren des Drehwinkelsensors
- Fig. 4: eine Tabelle mit Drehwinkelbereichen, Ausgängen der Reflexlichtschranken und entsprechendem 3-Bit Signal,
- Fig. 5 und Fig. 6: die beiden Teile einer Signalübertragungseinrichtung zeigen, in der der Drehwinkelsensor verwendet wird.

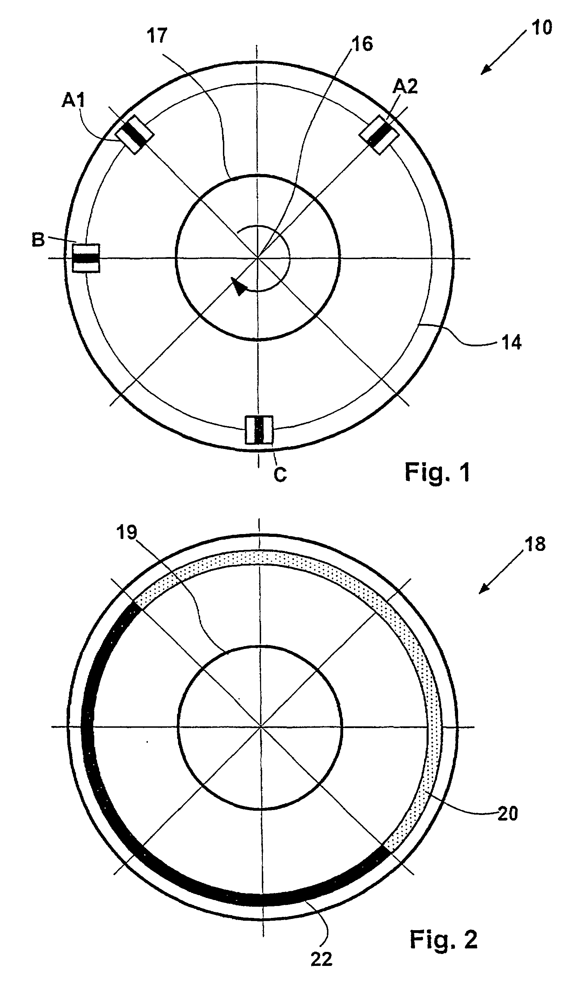

Fig. 1 zeigt schematisch, die geometrische Anordnung der Reflexlichtschranken A1, A2, B, C auf einer kreisscheibenförmigen Platine 10. Die Platine 10 kann beispielsweise drehfest mit einem Hubschrauberhauptrotor verbunden sein, wobei die Rotationsachse die Platine in dem mit 16 bezeichneten Mittelpunkt orthogonal schneidet. Für einen zentralen Durchlaß weist Sie im Bereich der Drehachse eine Bohrung 17 auf. Auf dem Kreisradius 14 sind die Reflexlichtschranken A1, A2, B, C des Drehwinkelsensors angeordnet.

Fig. 2 zeigt schematisch eine Platine, auf der die Abtastspur angeordnet ist. Die Abtastspur weist einen lichtreflektierenden Bereich 20 und einen lichtabsorbierenden Bereich 22 auf und ist im selben Radiusbereich angeordnet, wie die Reflexlichtschranken auf der Platine 10 (Fig. 1).

Der reflektierende Teil der Codespur kann beispielsweise als verzinnte Leiterbahn ausgebildet sein, und der lichtabsorbierende Teil kann mit einem mattschwarzen Lack versehen sein.

Auch die Platine 18 weist im Bereich der Drehachse eine Bohrung 19 auf.

Im montierten Zustand stehen sich die dargestellten Ansichten der beiden Platinen 10, 18 deckungsgleich mit einem geringen axialen Abstand gegenüber, so daß die Reflexlichtschranken A1, A2, B, C mit der Abtastspur 20, 22 zusammenwirken. Beispielsweise kann die Platine 10 verdrehbar sein und die Platine 18 drehfest mit einem nicht dargestellten Gehäuse verbunden sein.

Bei einer Verdrehung der Platine 10 gegenüber der Platine 18 überstreicht alle 45° jeweils eine der Reflexlichtschranken A1, A2, B, C eine Grenze zwischen reflektierendem Bereich 20 und absorbierendem Bereich 22 der Abtastspur. Der Ausgang der jeweiligen Reflexlichtschranke ändert sich dabei.

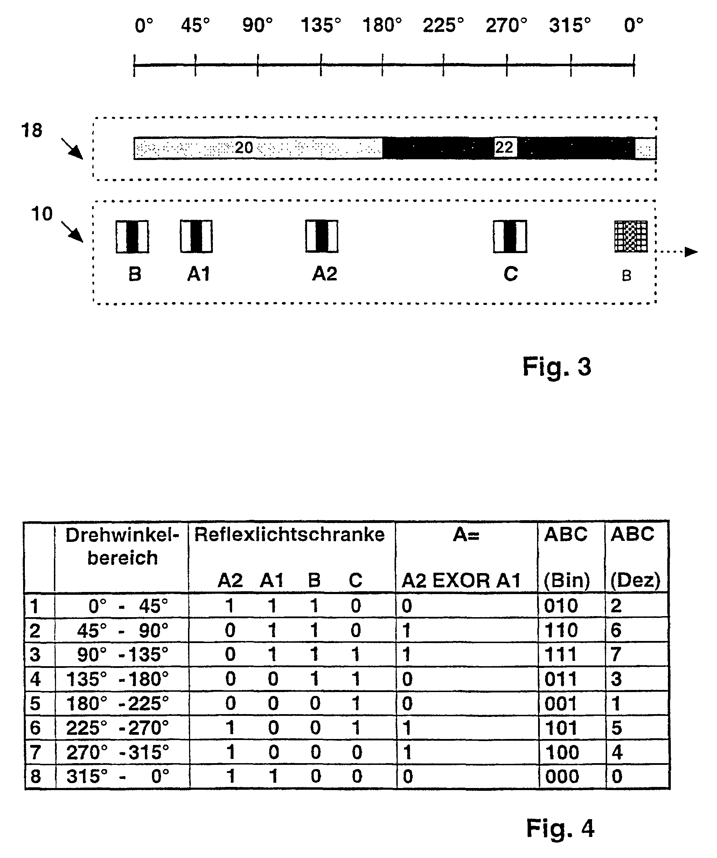

Fig. 3 zeigt eine Skizze der geometrischen Abwicklung der Anordnungen gemäß den Figuren 1 und 2. In der Abwicklung entspricht eine Drehung der Platine 10 gemäß der in Fig. 1 durch einen Pfeil gekennzeichneten Drehrichtung einer Relativbewegung der Platine 10 gegenüber der Platine 18 nach rechts. Dabei ist zu beachten, daß sich die Ansichten von Fig. 1 und Fig. 2 im montierten Zustand gegenüberstehen. In der in Fig. 3 dargestellten Stellung befindet sich die Reflexlichtschranke B gerade an der Grenze vom absorbierenden Bereich 22 zum reflektierenden Bereich 20. Wird entsprechend der Pfeilrichtung um 22,5° weiterbewegt, so wird die Mittelstellung des Drehwinkelbereichs 1 (0° - 45°) der Tabelle gemäß Fig. 4 erreicht. Bei dieser Stellung befinden sich die Reflexlichtschranken A2, A1 und B im reflektierenden Bereich 20 der Codespur und haben an Ihrem Ausgang demgemäß eine Spannung anliegen. In der dritten Spalte "Reflexlichtschranke" der Tabelle Fig. 4 ist dies jeweils durch eine "1" gekennzeichnet. Die Reflexlichtschranke C befindet sich im lichtabsorbierenden Bereich 22 der Codespur. An Ihrem Ausgang liegt keine Spannung an. Dies ist durch eine "0" gekennzeichnet.

Erfindungsgemäß werden die beiden Ausgänge der Reflexlichtschranken A2 und A1 mit einer "Exklusiv Oder" Verknüpfung verknüpft. Als Ergebnis erhält man das Signal "A", welches zusammen mit den Signalen der Reflexlichtschranken B und C ein 3-Bit Signal ABC bildet. In den beiden letzten Spalten der Tabelle gemäß Fig. 4 ist das 3-Bit Signal ABC binär und dezimal dargestellt.

An jeder Grenze eines jeweils 45° umfassenden Drehwinkelbereichs ändert sich der Ausgang einer Reflexlichtschranke. Wie aus der Tabelle Fig. 4 ersichtlich ist, werden mit der erfindungsgemäßen Anordnung bei einer vollen Umdrehung alle 8 möglichen Werte des Signals ABC jeweils einmal erzeugt. Es besteht ein eindeutiger Zusammenhang dieser Werte zu bestimmten Drehwinkelbereichen.

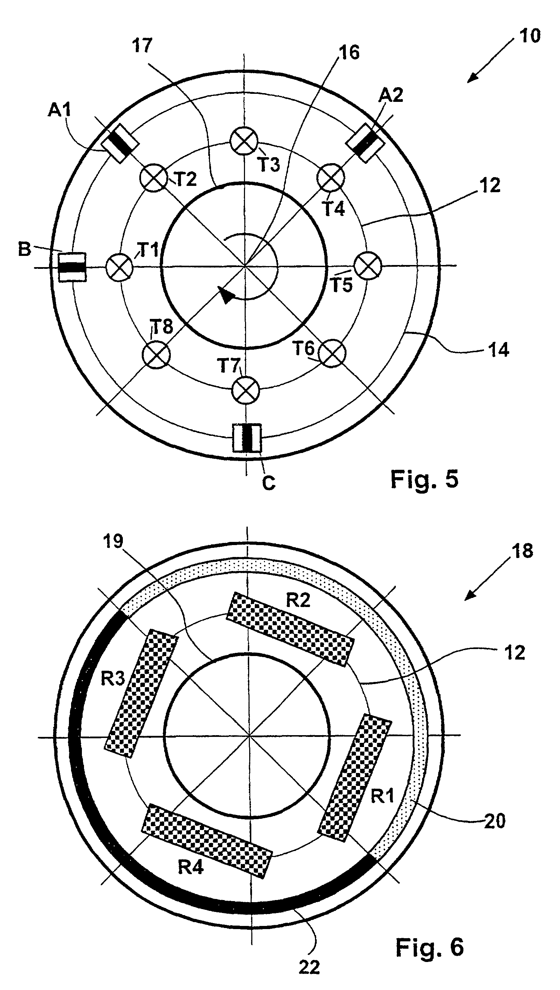

Dieser sehr einfache Drehwinkelsensor mit einer Auflösung von 45° kann vorteilhaft in einer in den Figuren 5 und 6 dargestellten Signalübertragungseinrichtung zur Übertragung von 4 Datenkanälen zwischen einem rotierenden System und einem feststehenden System verwendet werden. Dabei sind auf einem sendenden System (10) mehrere Sender (T1 - T8) und auf einem gegenüberliegenden empfangenden System (18) mehrere Empfänger (R1 - R4) angeordnet. Die Sender und Empfänger sind jeweils auf ringförmigen Bereichen 12 gleichmäßig verteilt angeordnet, so daß bei einer vollen Drehung des rotierenden Systems nacheinander jeder Sender jedem Empfänger gegenübersteht. Der erfindungsgemäße Drehwinkelsensor (A1, A2, B, C, 20, 22) dient zur Erfassung der jeweiligen Drehwinkelbereiche. Eine hier nicht dargestellte Senderumschalteinrichtung verwendet das Signal ABC des Drehwinkelsensors zur drehwinkelabhängigen Zuordnung von Datenkanälen zu Sendern.

Eine derartige Signalübertragungseinrichtung ist verschleißfrei, kompakt und ermöglicht hohe Übertragungsraten zwischen einem feststehenden und einem rotierenden System. Die Verwendung des erfindungsgemäßen Drehwinkelsensors ist auch deshalb sehr vorteilhaft, weil das Signal ABC direkt ohne weitere Aufbereitung von der Senderumschalteinrichtung verarbeitet werden kann.

### Bezugszeichen

- T1: Sender (LED)
- T2: Sender (LED)
- T3: Sender (LED)
- T4: Sender (LED)
- T5: Sender (LED)
- T6: Sender (LED)
- T7: Sender (LED)
- T8: Sender (LED)
- R1: Empfänger (Fotodiode)
- R2: Empfänger (Fotodiode)
- R3: Empfänger (Fotodiode)
- R4: Empfänger (Fotodiode)
- A1: Reflexlichtschranke
- A2: Reflexlichtschranke
- B: Reflexlichtschranke
- c: Reflexlichtschranke
- 10: Platine
- 12: Spur, Datenübertragung
- 14: Spur, Drehwinkelsensor
- 16: Drehzentrum
- 17: Bohrung
- 18: Platine
- 19: Bohrung
- 20: Abtastspur, reflektierend
- 22: Abtastspur, absorbierend

## Patentansprüche

1. Drehwinkelsensor mit zwei gegeneinander verdrehbaren Teilen, wobei auf dem ersten Teil (10) vier Abtastelemente vorgesehen sind, wovon drei an den Drehwinkelstellungen 0° (B), 45° (A1), 135° (A2) angeordnet sind, und wobei auf dem zweiten Teil (18) eine in sich geschlossene ringförmige binäre Codespur (20, 22) vorgesehen ist, welche in zwei verschiedene jeweils 180° umschließende Bereiche (20, 22) unterteilt ist und jeder Bereich jeweils einem Binärzustand entspricht, **dadurch gekennzeichnet, daß** das vierte Abtastelement an der Drehwinkelstellung 270° (C) angeordnet ist und ein Logikgatter mit einer "Exklusiv Oder" Verknüpfung vorgesehen ist, durch den die Ausgänge der Abtastelemente an den Drehwinkelstellungen 45° (A1) und 135° (A2) verknüpft sind, und daß die Ausgänge des Logikgatters und die Ausgänge der beiden Abtastelemente an den Drehwinkelstellungen 0° (B) und 270° (C) ein 3-Bit Signal für die Drehwinkelstellung bilden.

2. Drehwinkelsensor nach Anspruch 1, **dadurch gekennzeichnet, daß** die Abtastelemente (A1, A2, B, C) Reflexlichtschranken sind, ein Bereich (20) der Codespur lichtreflektierend ist, und der andere Bereich (22) der Codespur lichtabsorbierend ist.

3. Drehwinkelsensor nach einem der Ansprüche 1 oder 2, **dadurch gekennzeichnet, daß** die beiden gegeneinander verdrehbaren Teile (10, 18) scheibenförmig ausgebildet sind, und sich axial gegenüberstehen.

4. Drehwinkelsensor nach Anspruch 3, **dadurch gekennzeichnet, daß** im Bereich der Drehachse ein zentraler Durchlaß (17, 19) vorgesehen ist.

5. Drehwinkelsensor nach einem der Ansprüche 1 bis 4, **dadurch gekennzeichnet, daß** er zur UnterScheidung von acht jeweils 45° umschließenden Drehwinkelbereichen dient und in einer Signalübertragungseinrichtung zur Übertragung von Daten auf mehreren Datenkanälen zwischen einem rotierenden System und einem feststehenden System vorgesehen ist, wobei auf einem sendenden System (10), welches das rotierende oder das feststehende system sein kann, mehrere Sender (T1 - T8) und auf einem gegenüberliegenden empfangenden System (18) mehrere Empfänger (R1 - R4) angeordnet sind, wobei die Sender und Empfänger jeweils auf ringförmigen Bereichen gleichmäßig verteilt angeordnet sind, so daß bei einer vollen Drehung des rotierenden Systems nacheinander jeder Sender jedem Empfänger gegenübersteht, wobei eine mit dem Drehwinkelsensor verbundene Senderumschalteinrichtung zur drehwinkelabhängigen Zuordnung von Datenkanälen zu Sendern vorgesehen ist.

## Claims

1. Sensor for angles of rotation, having two parts which can be rotated in relation to one another, four scanning elements being provided on the first part (10), three of which are arranged at the angle-of-rotation positions 0° (B), 45° (A1), 135° (A2), and a closed annular binary code track (20, 22) being provided on the second part (18), which track is subdivided into two different areas (20, 22), respectively covering 180°, and each area respectively corresponding to a binary state, **characterised in that** the fourth scanning element is arranged at the angle-of-rotation position 270° (C) and a logic gate with an "exclusive or" operation is provided, by means of which the outputs of the scanning elements at the angle-of-rotation positions 45° (A1) and 135° (A2) are functionally connected, and **in that** the outputs of the logic gate and the outputs of the two scanning elements at the angle-of-rotation positions 0° (B) and 270° (C) form a 3-bit signal for the angle-of-rotation position.

2. Sensor for angles of rotation according to Claim 1, **characterised in that** the scanning elements (A1, A2, B, C) are reflection photoelectric barriers, one area (20) of the code track reflecting light and the other area (22) of the code track absorbing light.

3. Sensor for angles of rotation according to Claim 1 or 2, **characterised in that** the two parts (10, 18) which can be rotated in relation to one another are designed in the form of discs and face one another axially.

4. Sensor for angles of rotation according to Claim 3, **characterised in that** a central hole (17, 19) is provided in. the vicinity of the axis of rotation.

5. Sensor for angles of rotation according to one of Claims 1 to 4, **characterised in that** it is used to discriminate between eight angle-of-rotation ranges, respectively covering 45°, and is provided in a signal-transmission device for transmitting data to a plurality of data channels between a rotating system and a stationary system, a plurality of transmitters (T1 - T8) being arranged on a transmitting system (10), which may be the rotating system or the stationary system, and a plurality of receivers (R1 - R4) being arranged on a receiving system (18) lying opposite, the transmitters and receivers being respectively arranged uniformly distributed over annular areas so that, during a complete rotation of the rotating system, each transmitter successively faces each receiver, a transmitter switching device, connected to the sensor for angles of rotation, being provided for allocation of data channels to transmitters as a function of the angle of rotation.

## Revendications

1. Capteur d'angle de rotation comprenant deux parties pouvant tourner l'une par rapport à l'autre, dans lequel quatre éléments palpeurs sont prévus sur la première partie (10), dont trois sont disposés aux positions 0° (B), 45° (A1), 135° (A2), et dans lequel une piste de codage binaire annulaire (20, 22) refermée sur elle-même est prévue sur la deuxième partie (18), laquelle piste est divisée en deux régions différentes (20, 22) qui couvrent chacune 180°, chaque région correspondant à un état binaire respectif, **caractérisé en ce que** le quatrième élément palpeur est disposé à la quatrième position d'angle de rotation 270° (C), et il est prévu une porte logique comportant une combinaison "OU EXCLUSIF", par laquelle les sorties des éléments palpeurs situés aux positions d'angle de rotation 45° (A1) et 135° (A2) sont combinées, et **en ce que** les sorties de la porte logique et les sorties des deux éléments palpeurs situés aux positions d'angle de rotation 0° (B) et 270° (C) forment un signal à 3 bits pour la position d'angle de rotation.

2. Capteur d'angle de rotation selon la revendication 1, **caractérisé en ce que** les éléments palpeurs (A1, A2, B, C) sont des barrages photoélectriques à réflexion, une région (20) de la piste de codage est réfléchissante pour la lumière et l'autre région (22) de la piste de codage est absorbante pour la lumière.

3. Capteur d'angle de rotation selon l'une des revendications 1 ou 2, **caractérisé en ce que** les deux parties (10, 18) pouvant tourner l'une par rapport à l'autre sont en forme de disque et se font face dans la direction axiale.

4. Capteur d'angle de rotation selon la revendication 3, **caractérisé en ce qu'**un passage (17, 19) est prévu dans la région de l'axe de rotation.

5. Capteur d'angle de rotation selon l'une des revendications 1 à 4, **caractérisé en ce qu'**il sert à distinguer huit régions d'angle de rotation couvrant chacune 45° et il est prévu dans un dispositif de transmission de signaux destiné à transmettre des données sur plusieurs canaux de données entre un système tournant et un système fixe, plusieurs émetteurs (T1 - T8) étant disposés sur un système émetteur (10) qui peut être le système tournant ou le système fixe, tandis que plusieurs récepteurs (R1 - R4) sont disposés sur un système récepteur (18) qui lui fait face, les émetteurs et les récepteurs étant uniformément répartis sur des régions annulaires respectives, de sorte qu'au cours d'un tour complet du système tournant, chaque émetteur se trouve successivement face à chacun des récepteurs, un dispositif de commutation des émetteurs relié au capteur d'angle de rotation étant prévu pour associer les canaux de données aux émetteurs en fonction de l'angle de rotation.
